# EUROPEAN PATENT APPLICATION

(11) **EP 3 644 049 A1**
(43) Date of publication of application: **29.04.2020**
(21) Application number: 18202868.8
(22) Date of filing: 26.10.2018
(51) Int. Cl.: G01N 23/20025, G01N 23/20058, H01J 37/20, G01N 1/28

(54) **TOPOGRAPHICALLY STRUCTURED SUPPORT FOR ELECTRON CRYSTALLOGRAPHY**

(71) Applicant: PAUL SCHERRER INSTITUT, 5232 Villigen PSI (CH)
(72) Inventor: VAN BOKHOVEN, Jeroen A., 8044 Zürich (CH); GRUENE, Tim, 5234 Villigen (CH); WENNMACHER, Julian T.C., 5210 Windisch (CH)
(74) Representative: Fischer, Michael

(57) **Abstract**

It is therefore the objective of the present invention to provide a sample support that enables for example sub-micro range crystals to be deposited on the sample support in an arbitrary orientation although the crystals might have a preferred orientation.

This objective is achieved according to the present invention by a sample support for samples in the submicron range in imaging and diffraction techniques, comprising a topographically modulated surface; said surface comprising ridge-like and terrace-like structures having dimensions in the order of magnitude to the size of the submicron-sized sample.

Therefore, the topographical structure of ridge-like and terrace like section prevents the 3D crystalline probes from the deposition in a preferred direction due to the shape of the crystal structure on the probe support.

## Description

The present invention relates to a sample support for 3D samples in the submicron range for structure investigation by electron transmission systems.

The ever-growing interest in the atomic structures of submicron-sized crystals has led to the deployment of electron crystallography in transmission electron microscopes. Electron crystallography retrieves in nearly all of the cases incomplete structural data. The reason for this are crystals which shade their complete space from the sampling electrons by a preferred orientation on conventional sample supports. A new method of sample preparation and a new idea for the design of sample supports obstructs this preferred orientation. Thus sampling of the complete space from only very few crystals is enabled. This suggests that electron crystallography may become versatile and for the first time independent of the crystal shape. Moreover the adjustability of the introduced supports might access the complete space of various objects in transmission electron microscopes.

The overwhelming majority of molecular structures is solved with X-ray crystallography. Electron crystallography solves three-dimensional atomic structures from submicron crystals that are too small for X-rays. The largest drawback of this method is the difficulty to obtain complete datasets that are needed for an accurate structure determination. Most crystals obtain a preferred orientation on a conventional, flat sample support. This systematically shades part of the sample and renders it fruitless to combine data from several crystals to achieve full data completeness.

Many objects tend to have a preferred orientation. A flat box falls on one of its largest faces and needles do not stand on their tip. This affects material properties of such objects and affects how one can access such objects. Many imaging and diffraction techniques require three-dimensional access to a sample to obtain complete information. Preferred orientation of the sample often makes this impossible. In particular, methods that use electron radiation are particularly affected: The electron beam cannot penetrate the sample support, which is generally much thicker than the sample and which shades the sample from the electron beam. This creates a dead zone with no data, known as the missing wedge problem. Several methods address this problem: In two-dimensional electron crystallography and electron tomography, information of the missing wedge is partly recovered by phase and amplitude extrapolation. Three-dimensional crystals can be shaped by ion beam milling to enforce a different orientation, or they are embedded into a resin that disorders their preferred orientation. Data can also be completed with X-ray powder diffraction in a hybrid method approach. Every method that produces samples in a varying independent orientation makes it possible to combine data from several samples in order to increase completeness. The data quality is improved when the variation in orientation is random. Crystallography is particularly well suited for the combination of different data sets, because determination of the sample orientation is an essential part of data analysis. The correct combination of crystallographic data is well developed. In X-ray crystallography, the crystal is oriented by multi-axis goniometers. Many materials are transparent to X-rays, and shading does not prevent data to be collected from many orientations. In electron diffraction, the situation is very different. The strong interaction of electrons with matter that enables the study of micrometer- and nanometer-sized crystals, prevents electrons from penetrating most common sample supports, except for very few specialized cases. Since sample supports have a flat surface, any crystal with a flat shape and a low symmetry space group is going to result in incomplete datasets, even when data from many crystals are merged. A conventional sample support used in transmission electron microscopes (TEM) is a thin and flat carbon film transparent for electrons. It is stabilized by a copper or gold grid. The grid is non-transparent for electrons. This restricts the maximum available rotation angle to about 140° when the sample is centered between the grid bars. This is further reduced when the crystal lays off-center. The systematic lack of diffraction data leads to a distortion of the calculated electron potential map, which is the basis for the molecular model associated with an increased uncertainty in atom coordinates and atomic displacement parameters.

It is therefore the objective of the present invention to provide a probe support that enables for example sub-micro range samples to be deposited on the probe support in an arbitrary orientation although the samples might have a preferred orientation.

This objective is achieved according to the present invention by a sample support for 3D samples in the submicron range in electron microscopy, comprising a topographically modulated surface; said surface comprising ridge-like and terrace-like structures having dimensions in the order of magnitude to the size of the 3D samples.

Therefore, the topographical structure of ridge-like and terrace like section prevents the samples from the deposition in a preferred direction due to the shape of the crystal structure on the sample support.

A preferred embodiment can provide for a sample support where the topographically modulated surface is generated by brushing a carbon film having a thickness lower than 1 µm. By varying the pressure and/or the angle of the brushing the generation of the ripples can by controlled in the desired way.

Preferably, the 3D crystalline samples are distributed over the topographically modulated surface by the brushing. In other words, the 3D crystalline samples are deposited on the carbon layer prior to the brushing with a fine-haired brush and then distributed by the brushing. Coincidently, the samples adhere to the brushed carbon fibers by cohesion.

Another preferred embodiment can provide for a sample support where the topographically modulated surface is generated by distributing nanotubes and/or nano-cylinders, made for example of carbon and/or plastic, such as nylon, on a support grid, such as a carbon support grid. Typically for the intended use of the sample support, the nanotubes and/or nano-cylinders may have a diameter of 50 to 1000 nm. The density of the deposited nanotubes and/or cylinders was controlled with the deposition duration and thus could be adjusted to the particle size of the investigated crystal samples: lower density leaves larger holes.

The sample support as explained above can be used in an electron microscope.

The present invention therefore provides two examples for three-dimensional sample supports that produce complete datasets from only a few crystals. The first type creates the three dimensional sample support by wrapping an ultra-thin carbon layer. The second type is composed of chaotic nylon nano fibers. It is demonstrated that both types break the preferred orientation of MFI-type zeolite nano crystals without reducing data quality. In both cases, less than five crystals are sufficient to achieve complete data. The easy-to-obtain three-dimensional sample supports possess different features with versatile areas of application. Thus, it is anticipated that this kind of sample support will finally give rise to a broad range of complete three-dimensional reconstructions in TEM. This will allow for a more precise view on molecular and atomic structures of functional materials, chemical compounds, and proteins.

Preferred embodiments of the present invention are hereinafter discussed in more detail with reference to the attached drawings which depict in:
- Fig. 1: a conventional sample support used in X-ray and electron crystallography;
- Fig. 2: schematically a small section of the ZSM-5 framework;
- Fig. 3: the complete data from wrapped carbon grids used as sample support in electron crystallography; and
- Fig. 4: the complete data from carbon grids coated with 100nm nylon fibres used as sample support in electron crystallography.

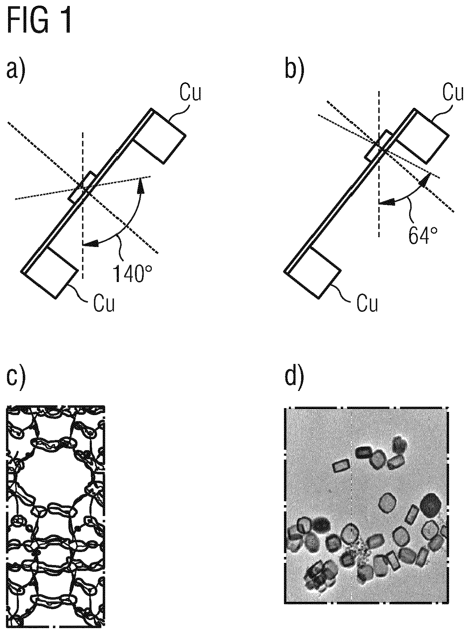

The present invention proposes a simple and generally applicable concept that solves the problem of the 'missing wedge' problem in electron microscopy by introducing sample supports with a three-dimensional structure. One approach wraps up a carbon surface of a thin carbon layer. Crystals to be investigated stick to the curved surface and thus have many different orientations. The second approach covers a sample grid with thin nylon fibres with a diameter similar to the crystal size. This creates a mesh that positions crystals in random orientations. The efficiency of each approach was determined using crystals of ZSM-5, a zeolite of the MFI framework. The habit of ZSM-5 crystals is akin a flat box. The direction of the short crystallographic c-axis coincides with the short macroscopic edge of the crystal. ZSM-5 crystals are therefore an ideal representative of submicron samples affected by preferred orientation. The chemically leaching of ZSM-5 leads to a cylindrical cavity that runs parallel to the crystallographic c-axis. This provides optical control of the preferred orientation of the crystallites (Fig. 1d). Fig. 1 illustrates that a conventional sample support leads to incomplete data. (a) When the crystal is centered between grid bars, the maximum rotation range is about 140°. (b) A crystal close to the grid bar reduces the maximum rotation range. (c) TEM micrograph of ZSM-5 crystals with preferred orientation. (d) The dark rim without interruption shows the leached channel parallel to the crystallographic c-axis.

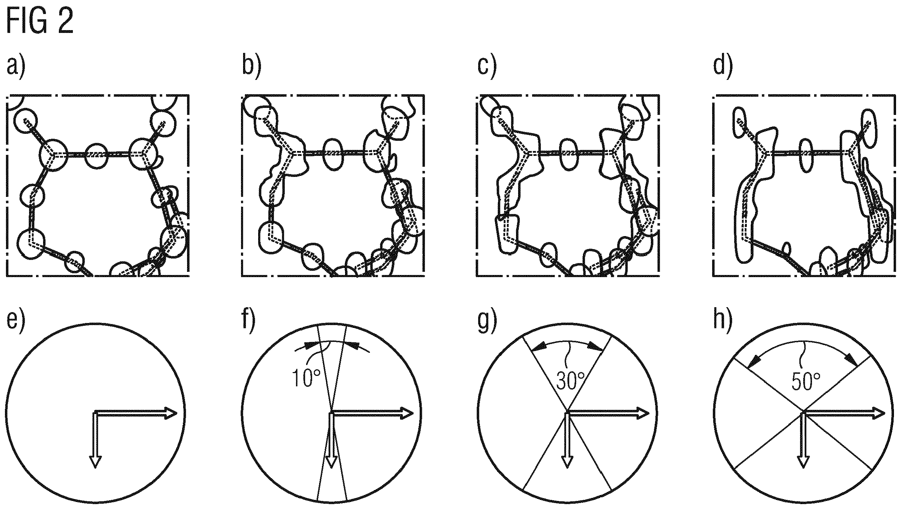

The effect of incomplete data is shown in Figure 2. With complete data, the electrostatic potential map is spherical centered about the every framework atom (Fig. 2(a)). Already with 10% data missing, the elongation of the map becomes obvious (Fig. 2(b-d)). The potential map elongates in the direction of the missing wedge. The elongation increases with increasing volume of the missing wedge. Figure 2 schematicalls illustrates a small section of the ZSM-5 framework. Missing wedge data leads to elongated electrostatic potential maps. (a) complete data. (b) missing wedge with 10° opening, 90% data completeness. (c) Missign wedge with 30° opening, 66% data completeness. (d) Missing wedge with 50° opening, 45% data completeness. (e) to (h) illustrate the missing volume in reciprocal space. Grey shaded: observed data, white wedge: missing data. Crystallographic b-axis in light grey, c-axis in dark grey.

### Wrapped Carbon-Film

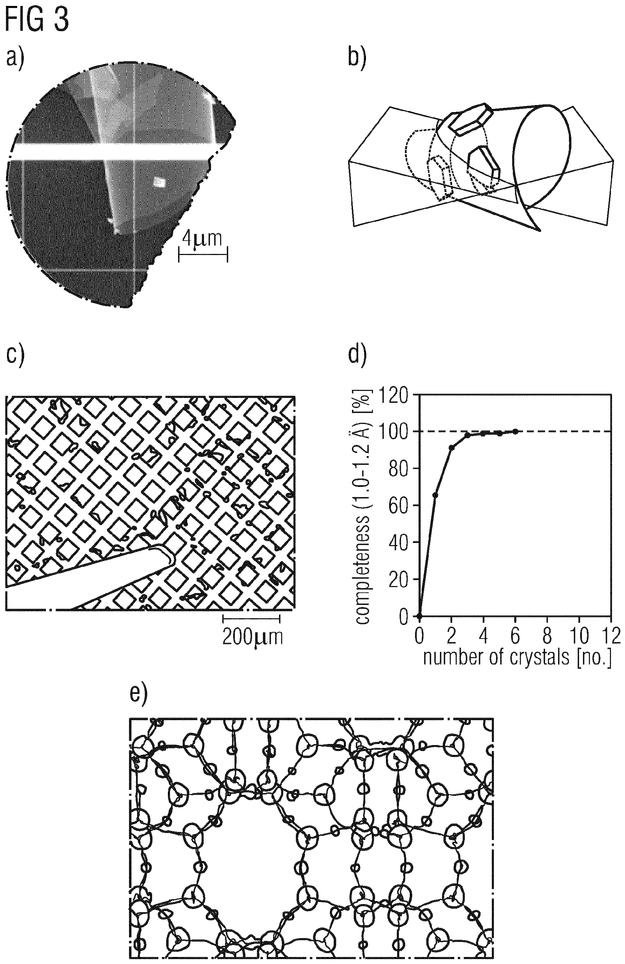

ZSM-5 crystals were deposited on a conventional, flat carbon support. Gentle striking of the carbon support with a fine-haired brush caused the carbon film to wrap up (Fig. 3(a)). Crystals attached to the carbon film surface, for example by cohesion or adhesion, followed the curvature induced by the soft brushing and thus changed their orientation (Fig. 3(a) and (b)). The degree of wrapping per mesh depends on the applied pressure and can be conveniently monitored with a light microscope (Fig. 3(c)). The direction of striking provides some control of the direction of the wrapping. Data of nine different crystals were collected. Merging all nine data sets together yielded 100% complete data. Subsequently, poorly fitting data sets, judged by the correlation coefficient of intensities between pairs of data sets, were manually excluded from merging as long as this did not reduce the data completeness. This way the number of required data sets could be reduced to only four data sets that yielded 100% complete data (Fig. 3(d)). A deterioration of the data quality was not observed. For each data set, it was possible to distinguish the crystallographic a-axis from the crystallographic b-axis based on data statistics.

Figure 3 illustrates the complete data from wrapped carbon grids. (a) STEM micrograph of wrapped carbon with attached ZSM-5 crystals. (b) Cartoon illustrating the randomized orientation. (c) The wrapping is visible with a light microscope. (d) Map calculated from 100% complete data from six crystals results in reliable atom positions (T-O bonds of ZSM-5 shown as bars).

### Plastic fibers, in particular nylon fibres

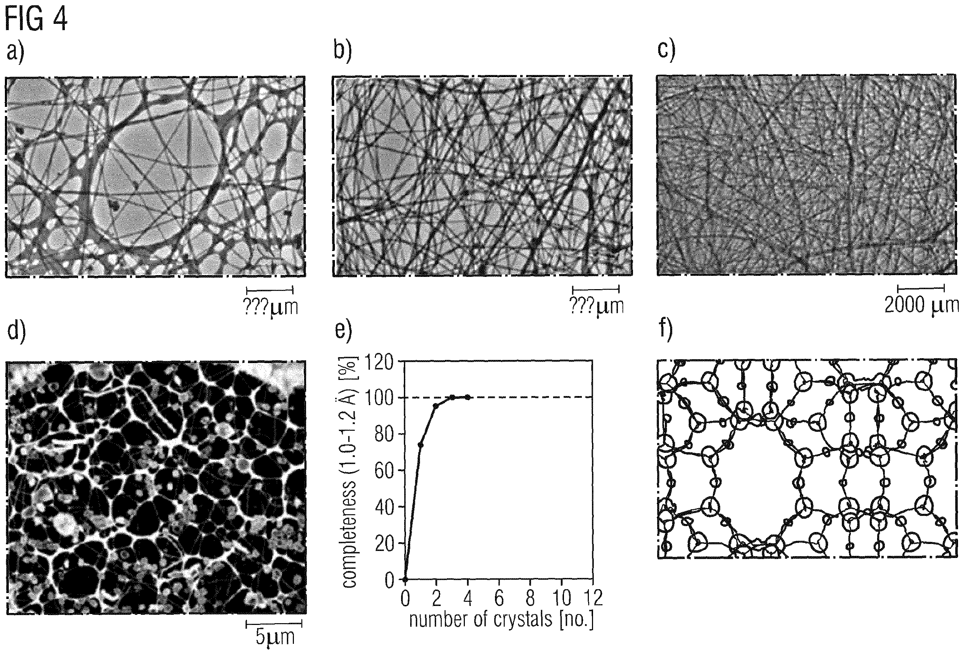

Nylon fibres with a diameter of about 100 nm were deposited on commercially available carbon grids. This created a chaotic network with open spaces of various diameter (Fig. 4(a), (b)). The density was controlled with the deposition duration and thus could be adjusted to the particle size of the investigated crystals: lower density leaves larger holes. The size of the ZSM-5 crystals was between 400 and 600 nm. Hence, the fibrous network and zeolite crystals have more or less matching dimensions. This match of dimensionality can be an important prerequisite for the sample holder. A network based on carbon nanotubes is applicable for single particle analysis, but it would appear flat for the large zeolite crystals. Fig. 4(c) shows zeolite crystals entangled in the nylon fibre network. The variation of orientation is less obvious than with the wrapped carbon film. Diffraction data were collected randomly from eight different crystals. The oscillation range for every crystal varied between 115° and 150°. Despite the seemingly lower variation in orientation, complete data was reached by merging diffraction data from four crystals (Fig. 4(d)).

Figure 4 depicts the complete data from grids coated with 100nm nylon fibres, (a) TEM micrograph of a nylon coated sample support with low fibre density (on top of lacey carbon). (b) TEM micrograph of a nylon coated sample support with mid fibre density. (c) TEM micrograph of a nylon coated sample support with high fibre density. (d) TEM micrograph of ZSM-5 crystals entangled in nylon fibres (on top of lacey carbon). (e) Four data sets reach 100% data completeness. (f) Map calculated from 100% complete data from six crystals results in reliable atom positions (T-O bonds of ZSM-5 shown as bars).

Imaging and diffraction techniques based on transmission electron microscopes are impeded by incomplete data, as electrons do not penetrate the sample support. In some applications, in particular in crystallography, multiple data sets can be merged to reach complete data. However, most crystals grow with a flat shape and lie on the sample support in preferred orientation. This is ruining the attempt to reach data completeness by merging.

The general idea of a topographically modulated surface of a probe support and two different types of sample support modification are disclosed herein that lead to a randomisation of the sample orientation and thus to complete data from very few measurements. Both types of sample support are applicable to any samples, both crystalline and non-crystalline, for which 3D structural information are to be obtained through the transmission of electron radiation or electromagnetic radiation like X-rays. Therefore, it will contribute to a deeper understanding of the structure and so the function of many materials. Both types of sample supports are easy to produce and have different properties (see Table 1). This provides a choice depending on the application. Wrapping the carbon layer of the sample support is an easy and fast method. The concept can be further refined through the precise engineering of a sample support, e.g. based on graphene. Plastic fibers, such as nylon fibres, are more reproducible and offer more control: both the fiber diameter and the fiber density can be adjusted to the specimen. The concept of nylon fibres is also suitable for sample deposition in a liquid environment and can also be used as a sieve, e.g. for the study of protein crystals in combination with vitrification. As also tomography can benefit from averaging of multiple data sets, the application of these grids may find applications outside the wide field of crystallography.

### Preparation of MFI crystals

ZSM-5 crystals were be prepared as described. Crystals were leached in NaOH solution (0.15 M, 35 ml/g zeolite) at 80°C for 10 h. The product was separated by centrifugation for 15 min at 15,000 rpm, washed three times and dried overnight at 100°C.

12 g tetrapropylammonium hydroxide solution (25 wt% in water) were added to a teflon reactor containing 12.5 g tetraethyl orthosilicate and 77.4 g deionized water. The mixture was heated to 80°C and stirred for 24 h at 500 rpm. After cooling down to room temperature, a solution of sodium hydroxide (0.24 g), aluminum nitrate nonahydrate (0.46 g) and deionized water (4 g) was added dropwise while stirring vigorously. The final gel composition of 0.01 Al₂O₃: 1 SiO₂: 0.25 TPAOH : 0.05 Na₂ : 80 H₂O and crystallization was performed in a stainless steel autoclave (100 ml). The product was separated by centrifugation for 15 min at 15,000 rpm, washed three times, dried overnight at 100°C and calcined for 10 h at 550°C.

### Preparation of Nylon 3D-Network

A nylon nanofiber grid supported by copper TEM grids (Lacey F/C 400 mesh Cu, Ted Pella Inc., USA) was prepared by an electrospinning process. Pellets with 15 wt% of Nylon-6 (particle size 3 mm, Sigma Aldrich, USA) dissolved in formic acid (purum ≥ 98.0%, Fluka, Germany) and high voltage (20 kV) was applied to the solution through a stainless steel needle on a plastic syringe. A syringe pump (NE-300, New Era Pump Systems Inc., USA) kept feeding the solution to the electrospinning system with 1.5 µl/min and the TEM grid was placed on the collecting plate made of stainless steel. Electro-spun nylon nanofibers were deposited on the grid for two minutes. The prepared nylon nanofiber grids were dried in the ambient condition for 24 hours.

### Sample Preparation

The MFI nano crystals were either applied as dispersion (1.5 mg/ ml) or as dust cloud generated by a paintbrush on a commercially available continuous carbon TEM grid (Ted Pella, 01843-F) respectively the nylon grids. The continuous carbon TEM grids were plasma-treated before. A fine-hair paintbrush was used to wrap up the continuous carbon film on the grids in a controlled way. According process can be observed by eye or targeted folding procedures of single meshes aimed with a light microscope. The grids were mounted with the mesh diagonal perpendicular to the rotation axis of the TEM sample holder.

### Data acquisition and processing

Data was collected at room temperature on a Tecnai F30 TEM equipped with a Schottky Emitter at an energy of E=200 keV, i.e. wavelength λ = 0.02508 Å. Dose in TEM Bright field mode was about 0.01 e⁻ Å⁻² (the precision of the reading is limited to two digits and displayed 0.00--0.01 e⁻ Å⁻². The Goniometer speed was accessed by a hand-written script and operated with a speed of 2.9°/ s. For data acquisition an Eiger X 1M proto-type detector was mounted on the TEM before. The read out time of the detector was set to 100 Hz and the data collected in continuous read-out mode at camera lengths of 715 and 495 mm. Resulting datasets were compressed in the HDF5 file format. Integration and optimisation of the data was executed by the program XDS. To control the correct assignment of the a- and b-axis all data sets were solved with direct methods with SHELXT in Laue group mmm. Only the framework atoms Si and O were provided without explicit atom counts. In some cases, SHELXT suggested either of the long unit cell axes as a-axis. In such cases, model refinement was carried out to select the setting with the better R1-value. From thereon, data of MFI crystals was processed without space group constraints, i.e. in Laue group 1⁻. Afterwards data was merged by the program XSCALE. The merged datasets again were solved by direct methods with the program SHELXT.

## Claims

1. A sample support for samples in the submicron range in imaging and diffraction techniques, comprising a topographically modulated surface; said surface comprising ridge-like and terrace-like structures having dimensions in the order of magnitude to the size of the submicron-sized sample.

2. The sample support according to claim 1 wherein the topographically modulated surface is generated by brushing a carbon film having a thickness lower than 1 µm.

3. The sample support according to claim 2 wherein the 3D crystalline probes are distributed over the topographically modulated surface by the brushing.

4. The sample support according to claim 1 wherein the topographically modulated surface is generated by distributing nanotubes and/or nano-cylinders, made for example of carbon and/or plastic, such as nylon, on a support grid, such as a carbon support grid.

5. The sample support according to claim 4 wherein the nanotubes and/or nano-cylinders have a diameter of 50 to 1000 nm.

6. An electron crystallography system comprising a probe support according to the any of the preceding claims.
